# EUROPEAN PATENT SPECIFICATION

(11) **EP 2 033 050 B1**
(45) Date of publication and mention of the grant of the patent: **27.02.2013**
(21) Application number: 07720180.4
(22) Date of filing: 06.06.2007
(51) Int. Cl.: G03F 7/00

(54) **MANUFACTURING A REPLICATION TOOL**
HERSTELLUNG EINES REPLIKATIONSWERKZEUGS
FABRICATION D'UN OUTIL DE RÉPLICATION

(30) Priority: 09.06.2006 US 423344
(43) Date of publication of application: 11.03.2009
(73) Proprietor: Heptagon Micro Optics Pte. Ltd., Singapore 539219 (SG)
(72) Inventor: RUDMANN, Hartmut, CH-8918 Unterlunkhofen (CH); WESTENHÖFER, Susanne, CH-8907 Wettswil (CH); HEIMGARTNER, Stephan, CH-6004 Luzern (CH); ROSSI, Markus, CH-8645 Jona (CH)
(74) Representative: Frei Patent Attorneys
(86) International application number: PCT/CH2007/000283
(87) International publication number: WO 2007/140643

(56) References cited:
- EP-A- 1 443 344
- EP-A- 1 527 870
- EP-A- 1 542 074
- WO-A-00/65408
- US-A- 3 767 445
- US-A1- 2003 217 804
- US-A1- 2004 229 140
- US-A1- 2005 052 583
- US-A1- 2005 058 948
- XIA Y ET AL: "SOFT LITHOGRAPHY" ANGEWANDTE CHEMIE. INTERNATIONAL EDITION, WILEY VCH VERLAG, WEINHEIM, DE, vol. 37, 1998, pages 551-575, XP000985399 ISSN: 1433-7851

## Description

### FIELD OF THE INVENTION

The invention is in the field of manufacturing, by replication, optical elements, in particular refractive optical elements or diffractive micro-optical elements. More concretely, it deals with a method of replicating an element and a process of manufacturing a plurality of optical elements.

### BACKGROUND OF THE INVENTION

Fabrication of optical elements by replication techniques, such as embossing or molding, has been known. Of special interest are the wafer-scale fabrication processes, where an array of optical elements is fabricated on a disk-like ("wafer-") structure, which subsequently to replication is separated ("diced") into the individual elements.

Replication techniques include injection molding, roller hot embossing, flat-bed hot embossing, UV embossing. As an example in the UV embossing process the surface topology of a master structure is duplicated into a thin film of a UV-curable replication material such as an UV curable epoxy resin on top of a substrate. The replicated surface topology can be a refractive or a diffractive optically effective structure, or a combination of both. For replicating, a tool (negative copy) is prepared from a master, which is then used to UV-emboss the epoxy resin. The master can be a lithographically fabricated structure in fused silica or silicon, a laser or e-beam written structure, a diamond turned structure or any other type of structure.

To achieve a cost effective mass production of replicated micro-optical components, a wafer-scale replication process is desirable. A 'wafer' in the meaning used in this text is a disc or a rectangular plate of any dimensionally stable, often transparent material. The diameter of the disk is typically between 5 cm and 40 cm, for example between 10 cm and 31 cm. Often it is cylindrical with a diameter of either 2, 4, 6, 8 or 12 inches, one inch being about 2,54 cm. The wafer thickness is for example between 0,2 mm and 10 mm, typically between 0,4 mm and 6 mm. The wafer-scale replication allows the fabrication of several hundreds identical structures with a single step, e.g. a single or double-sided UV-embossing process. The subsequent separating ('dicing') step of the wafer then yields the individual micro-optical components.

For an efficient wafer-scale replication technology a wafer-scale tool (negative copy of the replica to be manufactured) is required for fabricating the replica. Since such a waver-scale tool can only be used for a limited number of replication processes and since therefore a substantial number of wafer-scale replication tools are needed, it is also advantageous to have a wafer-scale sub-master (positive copy of the final replica to be manufactured), from which the replication tool may be cast or otherwise replicated. However, in many cases it is either not possible or very costly to directly produce a master or master tool that covers a sufficiently large area (typically at least 4 - 6 inches, up to 8 or 10 or 12 inches). For instance, mastering techniques such as e-beam writing or diamond turning typically cover only a small area in the range of several square mm which is only the size of an individual micro-optical component. Therefore, a process is required that closes the gap between the size of the individual component to the full wafer scale.

In WO 2005/057283 it has been proposed to manufacture a replication tool, sub-master or replica by means of a so-called recombination process. Recombination is the repeated replication of a single, small-scale structure over a large area, typically by embossing into a thermoplastic or thermosetting replication material. An embodiment of the recombination process disclosed in WO 2005/057283 relies on a so-called recombination framework, i.e., a framework of troughs into which the small-scale structure (master, sub-master or master tool) is replicated. This method features the substantial advantage that the position of the replicated structures with respect to all spatial dimensions is defined by the recombination framework. However, there are situations where a recombination framework is either not feasible, too laborious, or not suitable for the structure to be produced by the replication process.

US 2004/0229140 A1 discloses a method of forming a color filter layer including forming a first sub-color filter on a substrate by placing a first mold having at least a first groove on the substrate and injecting a first color resin into the first groove, the substrate including first, second and third regions and the first groove corresponding to the first region. The method further includes forming a second sub-color filter on the substrate by placing a second mold having at least a second groove on the substrate and injecting a second color resin into the second groove, the second groove corresponding to the first and second regions. And the method further includes forming a third sub-color filter on the substrate by placing a third mold having at least a third groove on the substrate and injecting a third color resin into the third groove, the third groove corresponding to the first, second and third regions.

WO 0065408 A1 discloses a method for forming a micro-pattern on a substrate, wherein a polymer material having a solvent is coated on the substrate, thereby forming a polymer film on the substrate. Then, a mold having a predetermined shape is compressed into the polymer film on the substrate by employing a predetermined compression technique to entail a plastic deformation of the polymer film, thereby patterning the polymer film. Before the mold is pressed into the polymer film, a free volume in the polymer film is previously increased so that a pressure applied on the polymer material needed to plastically deform the polymer film is reduced. Thereafter, etching is performed on the susbstrate through the use of the patterned polymer film as an etching mask, thereby forming a micro-pattern on the substrate.

In the publication "Soft Lithography" by Y. Xia and G. M. Whitesides, Angew. Chem. Int. Ed. 1998, 37, 570-575 (Wiley-VCH Verlag, D-Weinheim, Vol:37,Page(s):551 - 575), methods of eplica molding and embossing are disclosed, in particular with elastomeric stamps and molds. A use of such methods for the manufacture of optical structures is suggested.

In US 2005/058948 A1, it is suggested to fabricate microstructures by impinging a radiation beam, such as a laser beam, through a substrate that is transparent to the laser beam, into a negative photoresist layer on the substrate. The negative photoresist layer may be subsequently developed to provide a master for optical and/or mechanical microstructures. Related systems, microstructure products and microstructure masters also are disclosed.

US 2003/217804 A1 concerns a polymer micro-ring resonator and a method of manufacturing the same that is capable of providing reduced surface roughness and improved submicron gap separation between a waveguide and a micro-ring. Nanoimprinting is employed to achieve this without the need for a final lithography and etching step. According to a first method, a hard mold is used to directly imprint a polymer film to form optical waveguides in micro-ring devices. A second method employs a template filling approach, which allows a thicker waveguide to be fabricated, as well as polymers that are difficult to directly imprint.

In US 3 767 445 is disclosed a technique for producing integrated optical waveguides or circuits in which a substrate is embossed by a die of the desired guide pattern and is then coated with a liquid that fills the grooves and has sufficient surface tension to yield a greater thickness in the grooves than over adjacent substrate material. The liquid may be a solution of a higher-index optical material, solidifying in the grooves during evaporation of the solvent. Alternatively, a liquid monomer of a polymerizable higher-index material may be used which is subsequently polymerized in the grooves. This embossing and filling technique is particularly economical when a large number of replicas of a given optical circuit are to be produced.

EP 1 542 074 A1 concerns a process of manufacturing micro-optical, micro-mechanical or micro-fluidic components. A replication tool, a sub-master or a replica is manufactured using a structured element (for example a master) and a substrate. The substrate is provided with a recombination framework, the recombination framework comprising a plurality of troughs framed by the framework. A structure of the structured element is replicated into liquid or plastically deformable material disposed in a first one of said troughs, then hardened to make it dimensionally stable, whereon the structured element is removed. These replicating, hardening and removing steps are repeated for a second, third, etc. trough using the same structured element.

In US 2005/052583 A1, a method for forming a pattern of a liquid crystal display device is disclosed. The method includes providing a substrate having a layer to be patterned, providing a master substrate having an intaglio portion corresponding to a desired pattern, filling an organic material into the intaglio portion of the master substrate, placing the master substrate in contact with the substrate, hardening the organic material to produce a hardened organic film pattern, transferring the hardened organic film pattern onto a surface of the layer to be patterned by separating the master substrate from the substrate, and etching the layer to be patterned by using the organic film pattern as a mask.

EP 1 527 870 A2 relates to selective area stamping of optical elements which may be performed to make multiple micro-optic components on one or two sides of a substrate. This may be part of a batch process. The presence of molding material may be controlled on the substrate through the use of gaps. Excess amounts of optically curable polymer forced from between the stampers and substrate accumulate in gaps at the edge of plateau areas instead of being distributed as a film over the substrate. The stamper may be coated with a release layer. Metal alignment marks may be patterned for alignment purposes.

### SUMMARY OF THE INVENTION

It is therefore an object of the invention to provide an alternative method of fabricating an element to be used in a process of manufacturing, by replication, an optical element. The element shall include a plurality of structures replicated from a prototype, and should allow for a control at least of the thickness dimension (the z-coordinate) of the final replica.

Therefore, in a process of manufacturing, by replication, a plurality of optical elements each having geometrical surface features, a method of manufacturing an element that includes a plurality of replicated structures is provided. The method comprises the steps of providing an element substrate, of replicating, by embossing, a surface of a tool element, which surface comprises a negative copy of the geometrical surface feature, into replication material disposed at a first place on a surface of the element substrate, of subsequently hardening the replication material, of replicating said surface of the tool element into replication material disposed at a second place on said substrate, of hardening said replication material, the method comprising the further step of subsequently filling a gap between replication material disposed at the first place and replication material disposed at the second place by filler material, as it is defined in claim 1.

The element including a plurality of replicated structures may be a 'sub-master', i.e. an element that comprises surface portions corresponding to a positive copy of a surface portion of the optical element to be replicated. The tool element may be a so-called 'master tool', i.e. an element that comprises a surface portion corresponding to a negative copy of a surface portion of the optical element to be replicated.

The replication material may be disposed step by step, i.e. at the second place it is disposed after the replication material at the first place is hardened. According to a less preferred variant, the replication material may also be disposed at a plurality of places prior to being hardened. Then, the hardening step has to be carried out position selectively, for example by means of an appropriate mask where the hardening step includes curing a thermosetting replication material by means of illumination by electromagnetic or other radiation, such as UV radiation.

For the sake of convenience, the dimension perpendicular to the surface of the substrate, which comprises an essentially flat surface - is denoted as "height". In actual practice, the entire arrangement may also be used in an upside down configuration or also in a configuration where the substrate surface is vertical or at an angle to the horizontal. The according direction perpendicular to the surface is denoted z-direction. The terms "periphery", "lateral" and "sides" relate to a direction perpendicular to the z-direction.

The added filling material makes a complete control of the z-dimension of the crucial surface portions the final replica possible, even if its own thickness is not precisely controlled at all. This is because due to it the minimal thickness of the element produced may be at sections where the substrate is covered by the replication material and where the z-dimension relative to the replication section (the portion that will finally account for the desired optical properties of the optical element produced) has been defined by the replication. Such sections of minimal thickness correspond to protruding portions (spacer portions) of the tool replicated in a further replication step. They may be used to precisely define the thickness of the optical element.

In other words, this definition of the z dimension becomes possible since the structure of the tool that protrudes the most is next to the optical structures and is defined already in the single master or master tool.

In accordance with an other aspect of the invention, a process of manufacturing a plurality of optical elements each having surface features is provided, the process comprising the steps of providing a master or a master tool and carrying out at least a first and a second replication operation to replicate a surface portion of the master or master tool to provide a final replica, the first replication operation comprising a method of manufacturing an element including the steps of
- providing an element substrate,
- replicating, by embossing, a surface of a tool element, which surface comprises a negative copy of the geometrical surface feature, into replication material disposed at a first place on a surface of the element substrate,
- subsequently hardening the replication material,
- replicating said surface of the tool element into replication material disposed at a second place on said substrate,
- hardening said replication material,
- subsequently filling a gap between replication material disposed at the first place and replication material disposed at the second place by filler material,
the second replication operation including the steps of providing a second substrate and a second replication material disposed between the second substrate and said element, of moving the substrate and said element against each other, and of hardening the second replication material, as it is defined in claim 9.

Said element may be a sub-master. The second replication material may be of the same or of a different composition than the first replication material.

The tool by which the final replica is manufactured may in addition comprise alignment marks. The aligment marks are then added to the final replica by means of replicating the tool. The aligment marks may for example be placed at a peripheral position on the (wafer-scale) tool and may for example take the place of an element to be replicated in an array-like configuration on the tool. The aligment marks are preferably added to the sub-master or any other wafer-scale element in the generation process, by replicating an alignment mark master into replication material. Preferably, the aligment marks are added during the recombination step in the generation process.

The invention consequently also concerns

A process of manufacturing, by replication, a plurality of optical elements each having geometrical surface features as it is defined according to claim 10.

### BRIEF DESCRIPTION OF THE DRAWINGS

In the following, preferred embodiments of the invention are described referring to schematic drawings. None of the drawings is to scale. In the drawings:
- Fig. 1 schematically shows a generation process with a recombination step;
- Fig. 2 shows, in section, a replication tool;
- Fig. 3 shows a view of a sub-master during its manufacture;
- Fig. 4 shows, in section, a sub-master during its manufacture;
- Fig. 5 shows a flowchart of an embodiment of the method according to the invention;
- Fig. 6 shows a master tool according to an other embodiment;
- Fig. 7 shows, in section, during its manufacture, a sub-master made using the master tool of Fig. 6; and
- Fig. 8 shows a sub-master with replicated alignment marks.

### DESCRIPTION OF THE PREFERRED EMBODIMENTS

In this text, 'replication' is used for a process of 'casting' in a broad sense, i.e. of making a 'negative' copy of a structured portion of the element to be replicated. When the resulting element is again replicated, this leads to a 'positive' copy of the initially replicated element. In this text, elements that comprise surface parts being a negative copy of portions of the final optical element to be manufactured are called 'tools', for example 'replication tool' or 'master tool'. Elements including surface portions with a positive copy of the final element to be manufactured are called 'master', 'sub-master', or, for the final copy to be diced into the optical elements, 'final replica' or 'replica'.

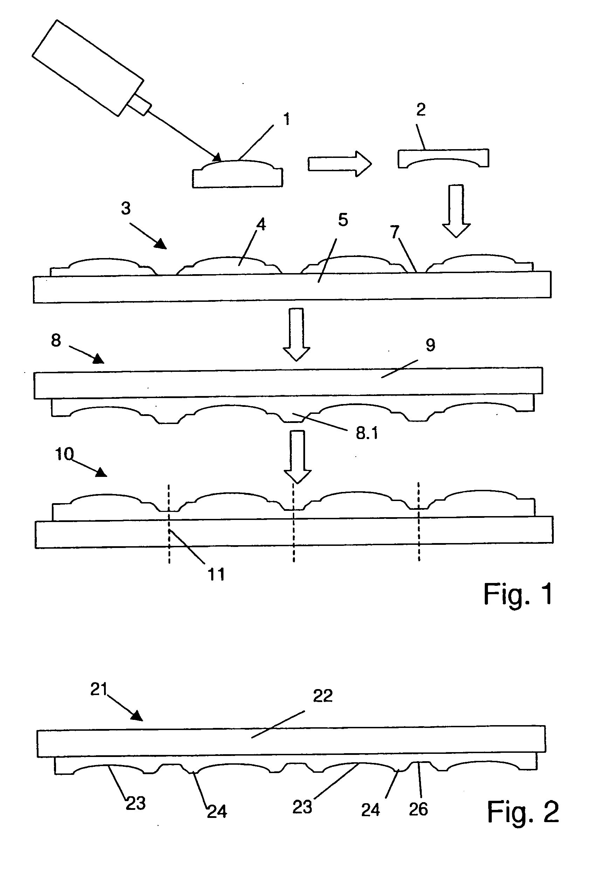

Figure 1 very schematically shows steps in a generation process for fabricating a plurality of optical elements by wafer-scale replication. In a first step, a master 1 is produced by any suitable method, such as diamond turning or an other method. In the figure, a laser beam writing process is symbolized. In the shown embodiment, the master 1 is replicated to yield a first generation tool 2 or master tool. In a recombination process at least one (second generation) sub-master 3 is manufactured. The sub-master in the shown embodiment is the result of a recombination operation and includes a plurality of portions 4 of replication material disposed at different places on a substrate 5, and each comprising an identical replicated structure being a negative copy of the master tool structure. From each sub-master, 2^{nd} generation replication tools 8 are produced which may be used for manufacturing the final replicas 10 (wafer with the micro-optical or micro-mechanical elements to be diced; dicing lines 11) or may be used for manufacturing next generation sub-masters.

In every one of the above steps not only one element but a plurality of elements may optionally be generated by replication. Thus, corresponding to an initial master, tens of master tools, hundreds of sub-masters, and thousands of replication tools may be manufactured.

In a production process it is also possible to initially fabricate, by a mastering operation such as laser beam writing or diamond turning, a master tool, i.e. a negative copy instead of a positive copy of the element to be finally replicated. Also as an alternative, the recombination step can also be applied in any generation, depending on the needs to preserve and protect the original structure. For example, the sub-masters or even the 2^{nd} generation replication tools may be small-dimension parts and comprise the structure to be replicated only once, so that the recombination process is used for producing the sub-master or the 2^{nd} generation replication tools, or the replica, respectively. In other words, the recombination may be applied in the 1^{st}, 2^{nd} or 3^{rd} generation etc. Also, a scale-up generation process may be envisaged, where recombination processes may be used in more than one stage, for example by using a small size master, a medium size 1^{st} generation replication tool, and 'large' size sub-masters or similar.

As to the replication material, in any one of the steps any suitable material which can be brought from a liquid or viscous or plastically deformable state into a state where it is dimensionally stable can be used. As an example, the replication material may be an epoxy, such as a UV curable epoxy. As a second example, the replication material may be PDMS. The replication material may but need not be identical for the different replication steps. Except for the final replication (depending on the nature of the optical element replicated), the replication material need not be transparent.

The replication process may be an embossing process or an other cast process. An example of such an other cast process is described in WO 2004/068198 with reference to Figures 14-16.

In the embodiment of the generation process described with respect to Figure 1, there remain gaps 7 between the portions 4 of replication material. If in the subsequent replication step the replication material is dispersed on the substrate 9, these gaps produce protrusions 8.1 in the negative copy. These protrusions 8.1, the height of which is not defined by the mastering process but is only defined to the extent that the distance between the master tool 2 and the substrate 5 in the replication steps of the recombination process is defined. This may be disadvantageous if spacer portions are used.

An example of a replication tool 21 for wafer-scale replication (as corresponding to the last step in the above-described generation process), which replication tool comprises spacer portions 24 is shown in section in Figure 2.

The replication tool 21 comprises a plurality of replication sections 23 i.e. negative structural features defining the shape of elements to be created with the tool. In the figure, a simple shape for a refractive optical element is shown, however, it is also possible to provide more sophisticated structures for refractive and/or diffractive optical elements. The replication tool further comprises spacer portions 24. The spacer portions 24 may at least partially surround the replication sections 23. The replication tool further comprises spill zones 26 for excess replication material. In the shown embodiment, the spill zones are located around the dicing lines, i.e. the lines where after replication, hardening and removing the replication tool the substrate with hardened replication material is separated into individual parts, is finally to be separated into the individual optical components. This need not be the case. Rather, spacer portions may cover the dicing lines, as has been described in the U.S. patent application 11/384,558 incorporated herein by reference.

At least some of the spacer portions may, during replication, abut the substrate. In addition or as an alternative, at least some of the spacer portions may be 'floating', i.e. a thin base layer of replication material may remain between the spacer portions and the substrate during final replication. The purpose of the spacer portions is one or a combination of the following:
- The spacer portions precisely determine a reference height of the replicated structures above the substrate.
- The spacer portions may absorb at least part of the force between the tool and substrate during replication.
- The spacer portions also allow the tool to adapt to irregularities of the planarity of the substrate.
- Spacer portions arranged along the dicing lines help to prevent delaminating of the replication material from the substrate.

The replication tool 21 further comprises a rigid back plate 22 to make it dimensionally stiff on a large scale.

As an alternative to the shown embodiment, the replication tool may be designed in accordance with the teaching of the international application publication WO 2004/068 198 and/or of any one of the U.S. applications 11/384,562, 11/384,537,11/384,563, and 11/384,558, which are assigned to the same company as the present application.

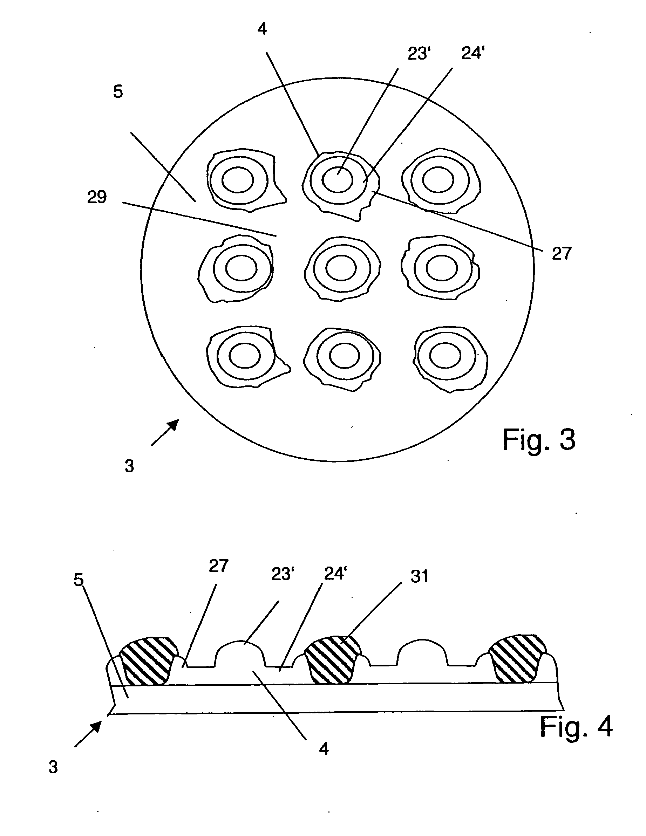

Figure 3 shows a very schematic example of a disk-shaped substrate 5 of a sub-master 3 after recombination. On the substrate, a plurality of replication material portions 4 is shown, each comprising the inverse of a replication section 23' and of a spacer portion 24' surrounding it. The remaining material 27 around the spacer portion has an undefined shape and height. Between the replication material portions 4, a gap 29 remains, where the substrate is not covered by replication material. In accordance with the invention, the at least one gap is now filled before the sub-master is used in the next replication step to cast a tool from it.

The substrate 5 - also called 'element substrate' in this text, for example has the approximate size and shape of an optical wafer, which latter is used for the final replica. However, in contrast to the optical wafer, the element substrate 5 need not necessarily be transparent.

The filling of the gap illustrated in Figure 4. The filler material 31 fills the entire space between the replication material portions. Its height is greater than the minimal height of the replication material portions at the place of the spacer portion 24'.

In accordance with a first embodiment, the gap is filled by a plastic material, such as an epoxy. It may be filled by material of the same composition as the replication material.

According to a second embodiment, the gap may be filled by material of a primarily metallic composition. Especially, the substrate 5 may be metallic or comprise a metallic surface, and the material may be added galvanically, i.e. by electroplating. For example, the filling may be made of nickel or copper added by electroplating.

Other variants of filling the gap may be envisaged.

The thickness of the filler material in the shown - preferred - embodiment is such that it exceeds the thickness of the replication material at the place of the spacer portions 24'. Therefore, the spacer portions of the tool cast from the sub-master protrude further than the portions at positions corresponding to the gap 29.

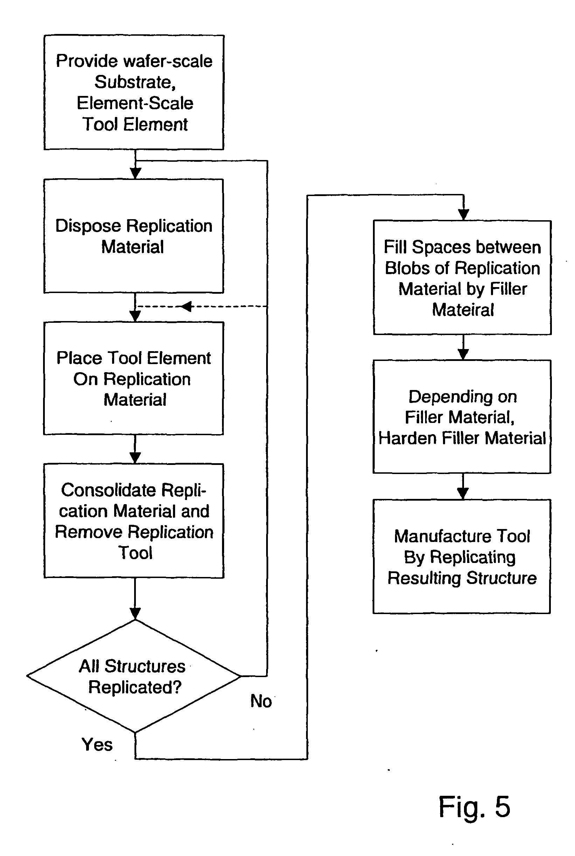

Figure 5 shows a flowchart summarizing steps in a process according to the invention.

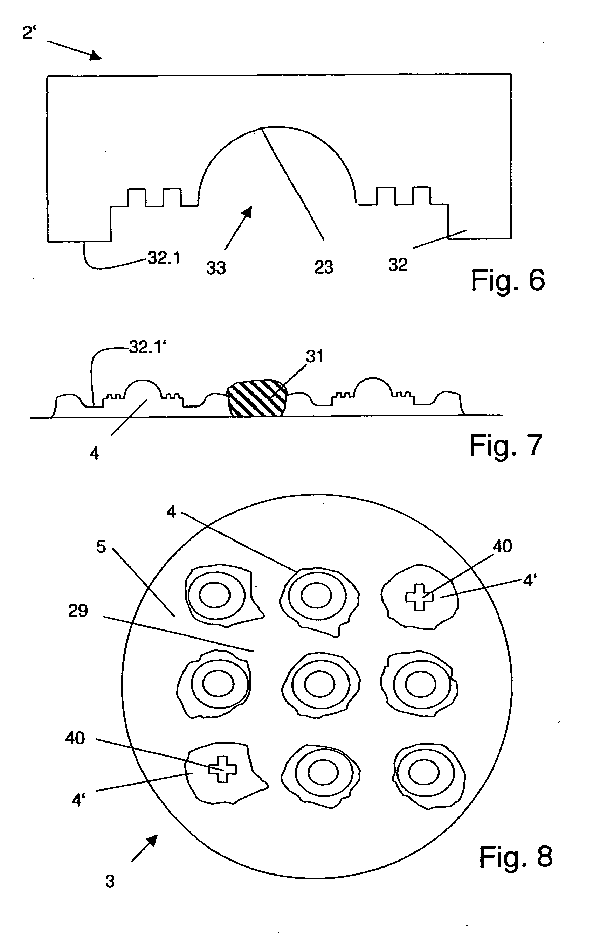

Figure 6 shows a variant of a master tool 2' with spacer portions 32 destined to be contact spacers, i.e. in the final replication process the corresponding replicated spacers of the wafer-scale tool are to contact the substrate and to abut its surface. The corresponding flat spacer surface 32.1 is defined already in the master and may thus be defined very precisely. In the final replication process, the cavity 33 defined by the tool and including the replication section 23 is only partially filled by replication material; it is filled at least to the extent that the space between the replication section 23 and the substrate is completely filled by the replication material. To do so, the replication material in the final, wafer-scale replication process is dispensed in portions, each optical element to be manufactured corresponding to one portion or to a plurality of portions. The edges of the angled structures 35 serve as flow stops for surplus material and account for the fact that the size of the dispensed material portions may not always be defined to an extent corresponding to the accuracy of the structures themselves. The individual dispensing of material portions for each element and the lateral confining of replication material is described in international patent applications PCT/CH 2007/000148 and PCT/CH2007/000146.

Also the variant of Figure 6, the advantages of the invention are evident. The flat surface 32.1 of the spacers that is very precisely defined will, due to the approach according to the invention, eventually define the height of the final replica elements (which are for example lenses), and thus the optical properties.

Figure 7 shows, in analogy to Fig. 4 the manufacturing of the sub-master 3 by recombination and subsequent filling of the space between the replication material portions 4 by filler material 31.

Figure 8 shows a variant of a sub-master 3 during a recombination process which comprises additional (in addition to the structures corresponding to the optical elements to be manufactured themselves) replicated structures. These additional structures will, like the other structures, be replicated to the tool and from there to the final replica. In the shown embodiment, the additional structures are alignment marks 40. Subsequently to the recombination process, the exact (x,y,z) positions of the alignment marks may be measured (such measurement is especially advantageous if the z position of the alignment marks will later be used, as the lateral (x,y) positions may be precisely defined by the recombination process itself). In the final replication step (for example in the case of two-sided replication) or thereafter (for alignment of different wafers in a stack of wafers), the alignment marks may be used for alignment.

Whereas preferably like in the shown embodiment the alignment marks 40 to be replicated are added to the sub-master by replication, into replication material 4' some alignment mark master, this need not be the case. They may also have been added by other means. They may also be added to a wafer-scale element in an other step in the generation process than to the sub-master.

The idea of providing on a tool or a sub-master (more in general: on a wafer-scale positive or negative copy of the elements to be finally replicated) alignment marks and of replicating them at least once to yield the final replica may be applied in combination with the idea, according to the invention, of filling spaces between replication material portions by filler material, or independently thereof.

The gap (or space) between the regions covered by the replication material may but need not be completely covered by the filler material 31. Rather, there may be regions to be kept free of replication material, for example in a peripheral region not used for replication or where after replication special measures are applied to the tool (such as adding a holder).

As a further variant, the tool element (for example master tool) does not necessarily comprise a structure corresponding to the negative copy of the surface of exactly one optical element. Rather, the tool element may encompass the (negative) structures of a few optical elements, for example of groups of four or six or nine optical elements.

Various other embodiments may be envisaged without departing from the scope of the invention.

## Claims

1. A method of manufacturing an element that includes a plurality of replicated structures for being used in a process of manufacturing, by replication, a plurality of optical elements each having geometrical surface features, the method comprising the steps of
- providing an element substrate,
- replicating, by embossing, a surface of a tool element, which surface comprises a negative copy of the geometrical surface feature, into first replication material disposed at a first place on a surface of the element substrate,
- subsequently hardening the first replication material,
- replicating said surface of the tool element into first replication material disposed at a second place on said element substrate,
- subsequently hardening said first replication material,
the method comprising the further step of
- subsequently filling a gap between first replication material disposed at the first place and first replication material disposed at the second place by filler material.

2. The method according to claim 1, wherein the gap between regions of material with replicated structures is filled to an extent that the thickness of the filler material is greater than a minimal thickness of material in the regions of replicated material.

3. The method according to claim 2, wherein master tool has a replicating surface which comprises flat sections where the height of the replicating surface is at a maximum, so that said flat sections define a region where the minimal thickness of the material with replicated structures is attained.

4. The method according to any one of the previous claims, wherein the filler material is a curable plastic material.

5. The method according to claim 4, wherein the filler material is a material of the same composition as the first replication material.

6. The method according to any one of the previous claims, wherein the element substrate comprises an electrically conductive surface portion and wherein the filler material is applied galvanically.

7. The method according to any one of the previous claims, wherein the element substrate has the size and shape of an optical wafer.

8. The method according to claim 1, wherein said surface of the tool element is, in consecutive sub-steps replicated into first replication material disposed at at least 40 places on said element substrate and wherein gaps between first replication material disposed at different places are filled by the filler material in a single step.

9. A process of manufacturing a plurality of optical elements each having surface features, the process comprising the steps of providing a master or a master tool and carrying out at least a first and a second replication operation to provide a final replica comprising surface portions being a positive or negative copy of a surface portion of the master or master tool, the first replication operation comprising a method of manufacturing an element according to claim 1, the second replication operation including the steps of providing a second substrate and a second replication material disposed between the second substrate and said element, of moving the substrate and said element against each other, and of hardening the second replication material.

10. A process according to claim 9, of manufacturing, by replication, a plurality of optical elements each having geometrical surface features, the process comprising the steps of
- providing an element substrate,
- replicating, by embossing, a surface of a replication tool, which surface comprises a negative copy of the geometrical surface feature, into replication material disposed between said substrate and said replication tool,
- subsequently hardening the replication material, and
- removing the replication tool, the replication material remaining attached to the substrate,
wherein the replication tool comprises alignment marks, and wherein said alignment marks are replicated into said replication material.

## Patentansprüche

1. Verfahren zur Herstellung eines Elementes, das mehrere replizierte Strukturen zur Verwendung in einem Herstellungsprozess, durch Replikation, mehrerer jeweils geometrische Oberflächenmerkmale besitzender optischer Elemente enthält, wobei das Verfahren die Schritte aufweist:
- Bereitstellen eines Elementsubstrates,
- Replizieren, durch Prägung, einer Oberfläche eines Werkzeugelementes, welche eine negative Kopie des geometrischen Oberflächenmerkmals aufweist, in an einer ersten Stelle auf einer Oberfläche des Elementsubstrates angeordnetes erstes Replikationsmaterial,
- anschließendes Härten des ersten Replikationsmaterials,
- Replizieren der Oberfläche des Werkzeugelementes in an einer zweiten Stelle auf dem Elementsubstrat angeordnetes erstes Replikationsmaterial,
- anschließendes Härten des ersten Replikationsmaterials,
wobei das Verfahren den weiteren Schritt aufweist:
- anschließendes Füllen eines Spaltes zwischen an der ersten Stelle angeordnetem ersten Replikationsmaterial und an der zweiten Stelle angeordnetem ersten Replikationsmaterial mittels Füllmaterial.

2. Verfahren nach Anspruch 1, wobei der Spalt zwischen Materialbereichen mit replizierten Strukturen in einem Ausmaß gefüllt wird, dass die Dicke des Füllmaterials größer als eine minimale Materialdicke in den Bereichen replizierten Materials ist.

3. Verfahren nach Anspruch 2, wobei das Masterwerkzeug eine replizierende Oberfläche besitzt, welche flache Abschnitte aufweist, in denen die Höhe der replizierenden Oberfläche maximal ist, sodass die flachen Abschnitte einen Bereich definieren, wo die minimale Dicke des Materials mit replizierten Strukturen erhalten wird.

4. Verfahren nach einem der vorstehenden Ansprüche, wobei das Füllmaterial ein härtbares Kunststoffmaterial ist.

5. Verfahren nach Anspruch 4, wobei das Füllmaterial ein Material mit derselben Zusammensetzung wie das erste Replikationsmaterial ist.

6. Verfahren nach einem der vorstehenden Ansprüche, wobei das Elementsubstrat einen elektrisch leitenden Oberflächenteilabschnitt aufweist und wobei das Füllmaterial galvanisch aufgebracht wird.

7. Verfahren nach einem der vorstehenden Ansprüche, wobei das Elementsubstrat die Größe und Form eines optischen Wafers hat.

8. Verfahren nach Anspruch 1, wobei die Oberfläche des Werkzeugelementes in aufeinanderfolgenden Teilschritten in ein an wenigstens vierzig Stellen auf dem Elementsubstrat angeordnetes erstes Replikationsmaterial repliziert wird und wobei Spalte zwischen an unterschiedlichen Stellen angeordnetem ersten Replikationsmaterial durch das Füllmaterial in nur einem Schrittgefüllt werden.

9. Prozess zur Herstellung mehrerer optischer Elemente, die jeweils Oberflächenmerkmale aufweisen, wobei der Prozess die Schritte Bereitstellen eines Masters oder eines Masterwerkzeugs und die Ausführen wenigstens einer ersten und einer zweiten Replikationsoperation zum Bereitstellen eines endgültigen Replikats mit Oberflächenteilabschnitten aufweist, die eine positive oder negative Kopie eines Oberflächenteilabschnittes des Masters oder Masterwerkzeuges sind, wobei die erste Replikationsoperation ein Verfahren zur Herstellung eines Elementes gemäß Anspruch 1 aufweist, die zweite Replikationsoperation die Schritte Bereitstellen eines zweiten Substrates und eines zwischen dem zweiten Substrat und dem Element angeordneten zweiten Replikationsmaterials, Bewegen des Substrates und des Elementes aufeinander zu und Härten des zweiten Replikationsmaterials aufweist.

10. Prozess nach Anspruch 9 zur Herstellung mehrerer optischer Elemente durch Replikation, die jeweils geometrische Oberflächenmmerkmale aufweisen, wobei der Prozess die Schritte aufweist:
- Bereitstellen eines Elementsubstrates,
- Replizieren, durch Prägung, einer Oberfläche eines Replikationswerkzeuges, welche eine negative Kopie des geometrischen Oberflächenmerkmals aufweist, in zwischen dem Substrat und dem Replikationswerkzeug angeordnetes Replikationsmaterial,
- anschließendes Härten des Replikationsmaterials, und
- Entfernen des Replikationswerkzeugs, wobei das Replikationsmaterial an dem Substrat verbleibt,
wobei das Replikationswerkzeug Ausrichtungsmarkierungen aufweist, und wobei die Ausrichtungsmarkierungen in das Replikationsmaterial repliziert werden.

## Revendications

1. Procédé de fabrication d'un élément qui comprend plusieurs structures répliquées et destiné à être utilisé dans un procédé de fabrication par réplication de plusieurs éléments optiques qui présentent chacun des caractéristiques géométriques de surface, le procédé comportant les étapes qui consistent à :
- prévoir un substrat d'élément,
- répliquer par étamper une surface d'un élément d'outil, la surface comprenant une copie négative de la caracteristique géométrique de surface, dans un premier matériau de réplication disposé en un premier emplacement de la surface du substrat d'élément,
- ensuite, durcir le premier matériau de réplication,
- répliquer ladite surface de l'élément d'outil dans le premier matériau de réplication disposé en un deuxième emplacement dudit substrat d'élément,
- ensuite, durcir ledit premier matériau de réplication,
le procédé comportant l'étape supplémentaire qui consiste à
- ensuite, remplir par un matériau de remplissage l'interstice situé entre le premier matériau de réplication disposé au premier emplacement et le premier matériau de réplication disposé au deuxième emplacement.

2. Procédé selon la revendication 1, dans lequel l'interstice entre les parties de matériau présentant des structures répliquées est rempli jusqu'à que l'épaisseur du matériau de charge soit supérieure à l'épaisseur minimale du matériau présent dans les parties constituées de matériau répliqué.

3. Procédé selon la revendication 2, dans lequel l'outil-maître présente une surface de réplication qui comprend des sections planes dans lesquelles la hauteur de la surface de réplication présente un maximum de telle sorte que lesdites sections plates définissent une zone dans laquelle l'épaisseur minimale du matériau présentant des structures répliquées est atteinte.

4. Procédé selon l'une quelconque des revendications précédentes, dans lequel le matériau de remplissage est une matière plastique durcissable.

5. Procédé selon la revendication 4, dans lequel le matériau de remplissage est un matériau qui présente la même composition que le premier matériau de réplication.

6. Procédé selon l'une quelconque des revendications précédentes, dans lequel le substrat d'élément comprend une partie de surface électriquement conductrice et dans laquelle le matériau de remplissage est appliqué galvaniquement.

7. Procédé selon l'une quelconque des revendications précédentes, dans lequel le substrat d'élément présente la taidimension le et la forme d'une plaquette optique.

8. Procédé selon la revendication 1, dans lequel ladite surface de l'élément d'outil est répliquée dans des sous-étapes consécutives dans le premier matériau de réplication disposé en au moins 40 emplacements sur ledit substrat d'élément et dans lequel les interstices entre le premier matériau de réplication disposé en différents emplacements sont remplis par le matériau de remplissage en une seule étape.

9. Procédé de fabrication de plusieurs éléments optiques qui présentent chacun des caractéristiques de surface, le procédé comportant les étapes qui consistent à prévoir un maître ou un outil-maître et à exécuter au moins une première et une deuxième opération de réplication pour obtenir une copie finale qui comprend des parties de surface qui sont des copies positives ou négatives d'une partie de surface du maître ou de l'outil-maître, la première opération de réplication comprenant un procédé de fabrication d'un élément selon la revendication 1, la deuxième opération de réplication comprenant les étapes qui consistent à prévoir un deuxième substrat et un deuxième matériau de réplication disposé entre le deuxième substrat et ledit élément, à déplacer le substrat et ledit élément l'un vers l'autre et à durcir le deuxième matériau de réplication.

10. Procédé selon la revendication 9 de fabrication par réplication de plusieurs éléments optiques qui présentent chacun des caractéristiques géométriques de surface, le procédé comportant les étapes qui consistent à :
prévoir un substrat d'élément,
répliquer par étamper une surface d'un outil de réplication, la surface comprenant une copie négative de la caractéristique géométrique de surface, dans le matériau de réplication disposé entre ledit substrat et ledit outil de réplication,
ensuite, durcir le matériau de réplication et
enlever l'outil de réplication, le matériau de réplication restant relié au substrat,
et dans lequel l'outil de réplication comprend des repères d'alignement et lesdits repères d'alignement sont répliqués dans ledit matériau de réplication.
